(19) Europäisches Patentamt
European Patent Office
Office européen des brevets

(11) EP 3 037 831 A1

(12) **EUROPEAN PATENT APPLICATION**

(43) Date of publication:
29.06.2016 Bulletin 2016/26

(51) Int Cl.:
*G01R 19/25* (2006.01)

(21) Application number: 14200271.6

(22) Date of filing: 24.12.2014

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: 23.12.2014 PL 41063314

(71) Applicant: **Akademia Gorniczo-Hutnicza im. Stanislawa Staszica w Krakowie 30-059 Krakow (PL)**

(72) Inventors:
• **Kolek, Krzysztof**
**30-150 Krakow (PL)**
• **Piatek, Krzysztof**
**30-718 Krakow (PL)**
• **Piatek, Pawel**
**31-221 Krakow (PL)**

(74) Representative: **Eupatent.pl**
**ul. Zeligowskiego 3/5**
**90-752 Lodz (PL)**

(54) **A system and a method for measuring power quality**

(57) A system for measuring power quality, the system comprising: a first processor; a computer-readable memory; and an interface communicatively coupled to A/D converters; the system further comprising: the first processor configured to execute a general-purpose operating system implementing communication procedures; a second processor configured to execute a real-time operating system dedicated for time-critical tasks; a reconfigurable hardware system, configured to be controller by the first processor, the reconfigurable system configured to execute at least one data processing algorithm and perform data acquisition from the interface communicatively coupled to A/D converters in order to measure power quality.

Fig. 1

## Description

The present invention relates to a system and a method for measuring quality of power. In particular the present invention relates to high speed measurement of alternating current power systems, and to adaptive or initiated by an operator modification of the functions of the device according to the measured quality values. The invention focuses on a method of rapid and flexible replacement of the functions of the measurement device by a new set of functions that fit to the current requirements of power quality evaluation.

Presently, an increasing number of devices are sensitive to quality of power supply. This increases the significance of monitoring of electric power at different levels of its delivery to a customer. Such monitoring helps to identify power quality problems, such as voltage sags and swells, interruptions, harmonics, and highfrequency spectral components. Addressing these problems requires accurate measurements and analysis of power quality with monitoring instruments that can effectively locate issues and identify problems.

The power quality measurement standards define methods for data acquisition and measuring of root-mean-square values, powers, voltage sag and swell parameters, unbalance, harmonics and flicker (e.g. as described by the following standards: IEC 61000-4-30, IEC 61000-4-7, IEC 61000-4-15, IEEE 1159, IEEE 1433, IEEE 1159). The measurement devices have to follow the standards in order to allow the comparison of the measurement results coming from the different meters. The methods presented in the standards require complex and time consuming calculations operating at high sampling rates (e.g. 10.24 kHz) that results in a requirement of applying multiprocessor configurations. Moreover, calculation of power quality indices requires computing processors of different characteristics e.g. event logging requires a fast processor equipped with significant amount of memory and flicker or harmonics calculation requires high computational power. Beside the power quality calculations, there is usually a need to communicate with the device over a popular communications protocol (e.g. IEC 60870-5-101, IEC 60870-5-104, IEC 61850, DNP3, OPC DA, OPC UA, HTTP, FTP) that requires the presence of an operating system and consumes the computational power of the processors.

The power quality measurement standards constantly evolve and every few years some new or updated requirements become obligatory. In order to follow the changes, power quality measurement algorithms should preferably be developed in a hardware-abstracted manner and the power quality devices should be able to update both the software and hardware configuration.

A US patent US5899960 discloses a power monitoring system with associated signal processing and storage capabilities. Each phase of the three-phase grid is simultaneously sampled on a plurality of channels to capture the instantaneous content of the power signal without time-skewing between the channels. In a further embodiment, the sampled data is converted into the frequency domain and parameters relating to the power quality of the power signal is derived from frequency-domain data. It is limited to a single, selected method of measurement and hence is neither high-speed not adaptive.

There is therefore a need for a high speed and adaptive detection of power quality.

SUMMARY

An object of the present invention is a system for measuring power quality, the system comprising: a first processor; a computer-readable memory; and an interface communicatively coupled to A/D converters; the system further comprising: the first processor configured to execute a general-purpose operating system implementing communication procedures; a second processor configured to execute a real-time operating system dedicated for time-critical tasks; a reconfigurable hardware system, configured to be controller by the first processor, the reconfigurable system configured to execute at least one data processing algorithm and perform data acquisition from the interface communicatively coupled to A/D converters in order to measure power quality.

Preferably, the data processing algorithm is at least one of filtering, calculating spectrum, flicker, logging events.

Preferably, the reconfigurable system further comprises a module implementing at least one protection algorithm.

Advantageously, the at least one protection algorithm calculates overcurrent or overvoltage integral of an input signal.

Preferably, the real-time operating system dedicated for time-critical tasks calculates at least one of rms values, flicker and asymmetry.

Advantageously, the second processor is configured to acquire A/D samples into buffers and periodically send the buffered data to the reconfigurable system for processing and to read the processing results.

Preferably, the second processor is configured to collect 2048 samples in the buffers and write, five times per second, the data of the buffers to an FFT calculation block of the reconfigurable system.

Preferably, the system is configured to update the at least one data processing algorithm via a reconfiguration process.

Another object of the present invention is a method for measuring power quality in the system according to the present invention, the method comprising the steps of: awaiting till the beginning of each sampling period; starting A/D conversions; awaiting for the conversion-completed signal; reading the conversion results; and outputting the results are set together with a timestamp value read from a GPS receiver.

Preferably, the method further comprises the steps of: processing the output results by an event detection block, implemented in the reconfigurable system, configured to detect abnormal events; storing the output results in a memory buffer; processing the output results in order to detect measured properties being outside a safe operating range.

Advantageously, the method further comprises a steps of: detecting a condition that requires a new function; updating the hardware configuration of the reconfigurable system; processing the input data according to the new hardware configuration.

Another object of the present invention is a computer program comprising program code means for performing all the steps of the computer-implemented method according to the present invention, when said program is run on a computer.

Yet another object of the present invention is a computer readable medium storing computer-executable instructions performing all the steps of the computer-implemented method according to the present invention, when executed on a computer.

BRIEF DESCRIPTION OF DRAWINGS

These and other objects of the invention presented herein, are accomplished by providing a system and method for measuring quality of power. Further details and features of the present invention, its nature and various advantages will become more apparent from the following detailed description of the preferred embodiments shown in a drawing, in which:

Fig. 1 presents a diagram of part of the system which contains the first and the second processor, reconfigurable hardware system and A/D converters interface;
Fig. 2 presents a diagram of the measurement process of a channel according to the present invention;
Fig. 3 presents a Finite State Machine configuration;
Fig.4 shows a sampling process with timing arrangement; and
Fig. 5 shows the method for measuring quality of power according to the present invention.

NOTATION AND NOMENCLATURE

Some portions of the detailed description which follows are presented in terms of data processing procedures, steps or other symbolic representations of operations on data bits that can be performed on computer memory. Therefore, a computer executes such logical steps thus requiring physical manipulations of physical quantities.

Usually these quantities take the form of electrical or magnetic signals capable of being stored, transferred, combined, compared, and otherwise manipulated in a computer system. For reasons of common usage, these signals are referred to as bits, packets, messages, values, elements, symbols, characters, terms, numbers, or the like.

Additionally, all of these and similar terms are to be associated with the appropriate physical quantities and are merely convenient labels applied to these quantities. Terms such as "processing" or "creating" or "transferring" or "executing" or "determining" or "detecting" or "obtaining" or "selecting" or "calculating" or "generating" or the like, refer to the action and processes of a computer system that manipulates and transforms data represented as physical (electronic) quantities within the computer's registers and memories into other data similarly represented as physical quantities within the memories or registers or other such information storage.

A computer-readable (storage) medium, such as referred to herein, typically may be non-transitory and/or comprise a non-transitory device. In this context, a non-transitory storage medium may include a device that may be tangible, meaning that the device has a concrete physical form, although the device may change its physical state. Thus, for example, non-transitory refers to a device remaining tangible despite a change in state.

As utilized herein, the term "example" means serving as a non-limiting example, instance, or illustration. As utilized herein, the terms "for example" and "e.g." introduce a list of one or more non-limiting examples, instances, or illustrations.

DETAILED DESCRIPTION

The present invention focuses on a method of rapid and flexible replacement of functions of a measurement device with a new set of functions that fit current requirements of a power system.

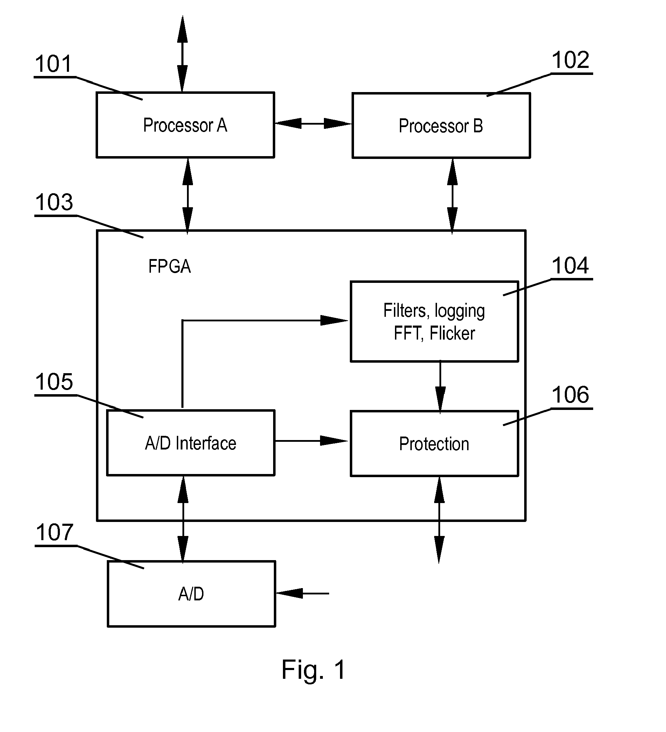

Fig. 1 presents a diagram of part of the system according to the present invention. The architecture of the device to measure power quality, uses preferably a multi-core processor and a reconfigurable digital integrated circuit and divides the tasks related to the implementation of algorithms for measuring the quality of electricity between a first processor 101 executing a general-purpose operating system implementing communication procedures and performing data acquisition, a second processor 102 running a real-time operating system dedicated for time-critical tasks and a reconfigurable system 103 responsible for the hardware implementation of selected processing algorithms 104 (e.g. filtering, calculating the spectrum, flicker, logging events).

The reconfigurable system 103 may further comprise an interface to A/D converters 105 the properties of which will depend on the power range to be measured and sensors applied for the measurements. Additionally, the reconfigurable system 103 may further comprise a module implementing at least one protection algorithm 106.

The protection algorithm(s) module, may for example implement an algorithm that calculates the overcurrent or overvoltage integral of an input signal:

$$I_i = \frac{1}{N} \sum_{i=0}^{N-1} i \quad \left( i \, i - i - I_{NOM} \right) \quad I$$

or

$$U_i = \frac{1}{N} \sum_{i=0}^{N-1} i \quad \left( i \, i - i - U_{NOM} \right) \quad U$$

where $I_i$ and $U_i$ are cumulative overcurrent and overvoltage values, $I_{-i}$ and $U_{-i}$ and current and voltage values for last $N$ samples and $I_{NOM}$ and $U_{NOM}$ are nominal current and voltage values. If the calculated values exceed a given value, the system may trigger suitable protection procedures. The advantage of the protection algorithm implemented as a part of the reconfigurable circuit, is that it is not disturbed by software running at the main processor(s).

The reconfigurable modules may be realized using suitable, custom made or configurable FPGA (Field-Programmable Gate Array) or ASIC (Application Specific Integrated Circuit) circuits.

The system may communicate with a suitable communication interface with one or more memory circuits for storing temporary and final results data as well as computer program or programs executed by either of the first or second processor. The architecture, according to the present invention, utilizes two general purpose processors 101, 102 and a reconfigurable circuit 103, each operating in a different time domain.

The first processor 101 runs a general purpose real-time operating system (for example Linux) and is responsible for: communication over communication protocols such as Ethernet and serial link protocols (eg. FTP, HTTP, SSL, IEC 60870-5-101/104, IEC 61580, RS-232, Modbus, etc.), data presentation, communication with the second processor 102 and supervision of the reconfigurable circuit 103.

The second processor 102 runs a real-time operating system (for example FreeRTOS or QNX) and is responsible for the operations that require real-time execution constraints. It runs preferably at, but not exclusively set to, 10.24 kHz sampling frequency and calculates at least one of: rms values, flicker and asymmetry.

The communication functions of the processor 101 require a generic purpose operating system that cannot fulfil real-time timing constraints. The general-purpose system contains more functions but is not fast and deterministic enough to perform fast and accurate sampling. Therefore, two processors have been used.

The second processor 102 also acquires A/D samples from voltage and current input channels in the buffers and periodically sends the buffers to the reconfigurable circuit 103 for FFT calculation and reads the calculated FFT spectrum. According to the power quality calculation specifications, an FFT of each signal is calculated every 200 ms for last 2048 samples (10.24 kHz sampling generates 2048 samples every 200 ms for each measured signal). The 102 processor collects the 2048 samples of each sampled signal in the buffer and periodically five times per second writes the buffer (sends the buffer) to the FFT calculation block. The FFT block is a kind of a coprocessor that performs only one operation - calculates the spectrum.

The reconfigurable circuit 103 is responsible for interfacing to the A/Ds, for the calculation of the FFT algorithm and for the execution of the protection algorithms. The protection algorithms are implemented directly in the reconfigurable circuit 103 as an IP core. The protection algorithms process current and voltage measurements directly from A/D and detect the violation of safety conditions independently on any processor 101, 102.

The aforementioned setup results in very high speed detection time, which usually remains below 10 nanoseconds.

Signal processing algorithms for the system, according to one aspect of the present invention, may be developed in a graphical programming language (for example Simulink). It allows to develop the algorithms in a hardware-abstracted manner. From the graphical programming environment there is automatically generated: (a) high-level programming language code e.g. C, when the algorithm is designed to be executed by processor 101 or 102, (b) hardware description language code e.g. HDL, when the algorithm is designed to be implemented as IP core in the reconfigurable circuit 103. There are added wrapper procedures to the generated code in order to integrate the generated code with the system. The wrapper procedures are developed for a given, target hardware platform and they call the procedures from the generated code. Such an approach splits the development into two paths: algorithms are developed in a hardware abstracted manner in a graphical environment for automatic code generation and the wrapper procedures are developed to utilise the generated code at a given target hardware platform.

A unique feature of the solution is that if a wrapper code is changed, the algorithm is automatically executed by another hardware platform and if algorithms are changed (e.g. forced by the updates in the power quality measurement standards), the changes are done only in a graphical environment, that results in an automatic generation of all software files needed to implement the updated algorithms.

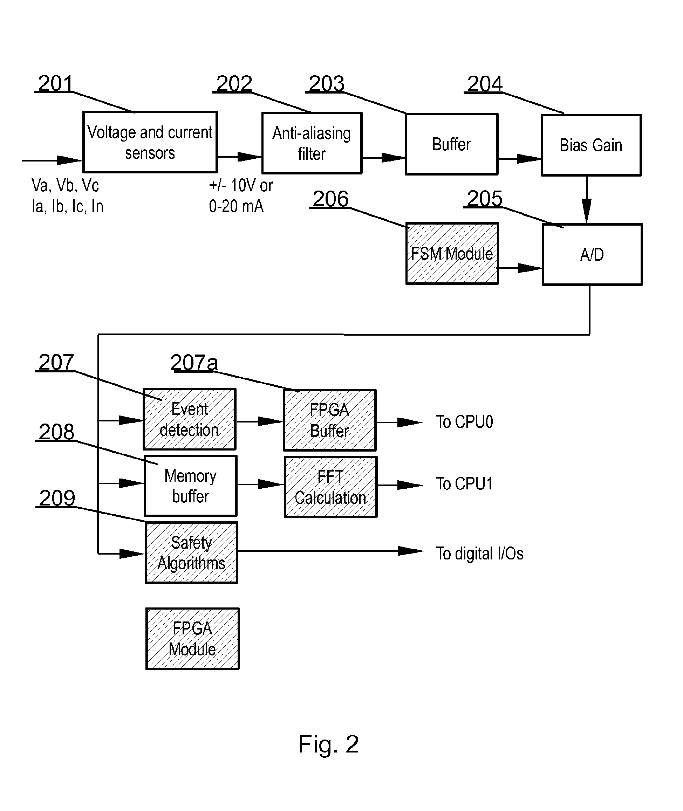

Fig. 2 presents a diagram of the measurement process according to the present invention. The measurement process is executed in a sequence of circuits that may comprise: a voltage or current sensor 201, an anti-aliasing filter 202, a buffer 203, bias and/or gain amplifiers 204 and an A/D converter 205. The A/D converter 205 is controlled by a Finite State Machine 206 implemented in the reconfigurable circuit 103.

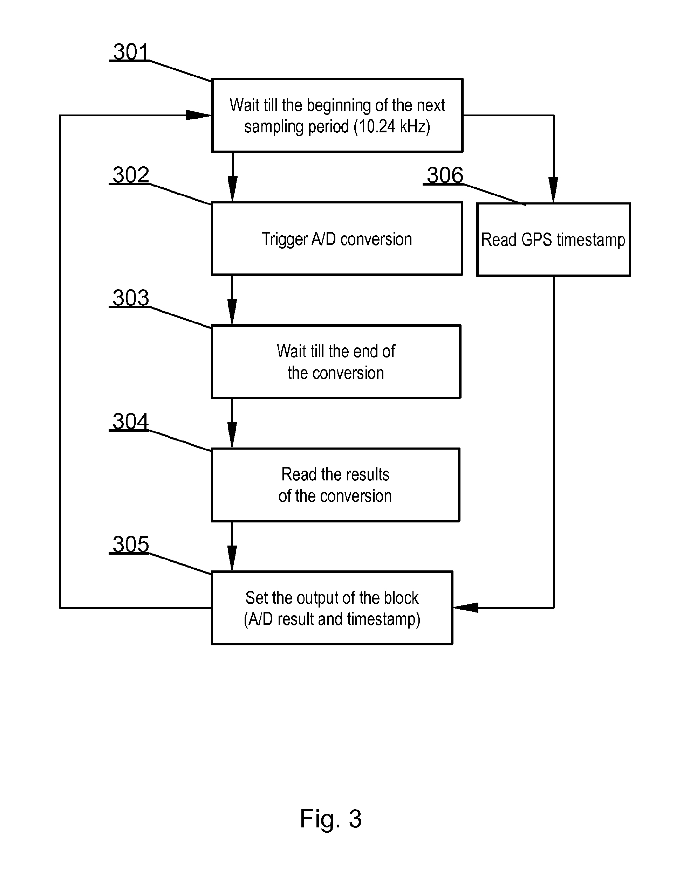

The Finite State Machine 206 is configured to wait till the beginning of each sampling period 301 and start the A/D conversions 302. Subsequently the Finite State Machine 206 waits for the 'conversion completed' signal 303 and reads 304 the conversion results, as shown in Fig. 3. At the output of the block the results are set 305 together with a timestamp value read from a GPS receiver 307.

The sections of Fig. 2 denoted by dashed background are implemented by the reconfigurable circuit 103.

The results of the A/D conversion are (a) sent to the second processor 102 in order to calculate the power quality parameters; (b) sent to an event detection block 207. The events (e.g. over-voltage, sag, swell, etc.) are detected by the reconfigurable circuit 103 and the signal waveform containing the event is stored in the reconfigurable circuit's 103 memory buffer 207a. The data stored in the memory buffer 207a may be processed by the first processor 101 (e.g. stored in a database or used for the purpose of calculations of events' statistics).

Additionally, the results of the A/D conversion are (c) stored in a memory buffer 208 and periodically (for example every 200ms) used to calculate a spectrum by running an FFT algorithm implemented as an IP core in the reconfigurable circuit 103.

Finally, the results of the A/D conversion are (d) processed by the safety algorithms 209 in order to detect measured properties being outside a safe operating range (for example of a receiver circuit supplied with power e.g. a transformer). The safety algorithms 209 block automatically executes an action when safe conditions are not met. The algorithms are implemented as IP core(s), in the reconfigurable circuit 103, and they operate independently on the first and/or second processor 101, 102.

In one aspect of the present invention, the results of the A/D conversions are further processed in order to calculate: rms values, total harmonic distortion (THD), asymmetry and flicker.

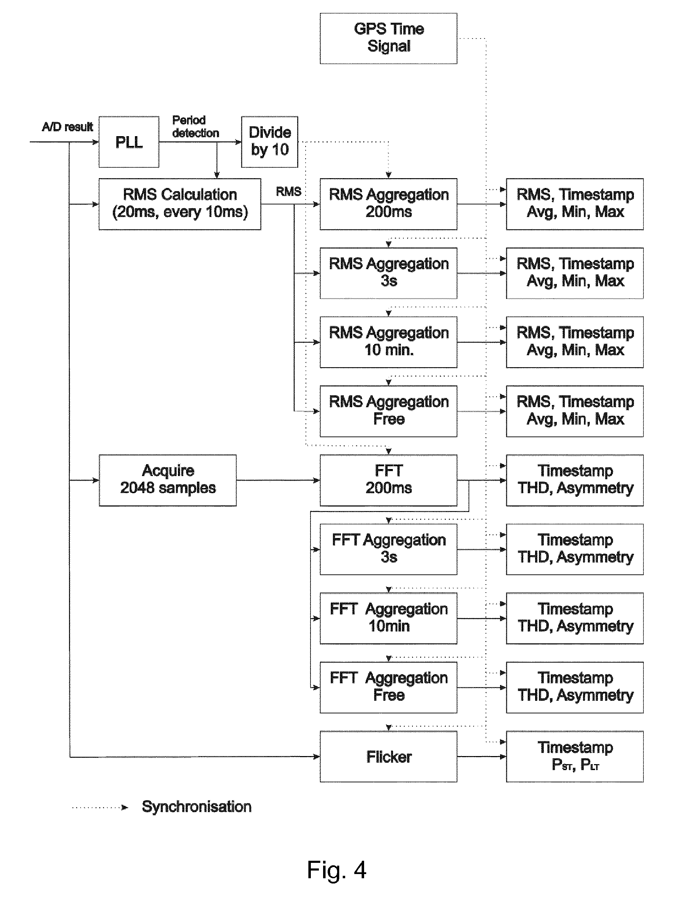

The rms measurement, as shown in Fig. 4, is synchronized by a PLL module to a grid signal, i.e. the voltage signal of one of the power phases. The rms is calculated every half-period (10 ms) of the grid signal for last period of the signal (20 ms). The 10 ms rms values are aggregated in four time periods: 200 ms, 3 seconds, 10 minutes and an arbitrary interval (free interval). The 200 ms period is synchronized to the grid signal and the remaining periods are preferably synchronized to GPS (Global Positioning System) time signal. The aggregation blocks calculate the average, minimum and maximum 10 ms rms values.

The second processor 102 acquires a buffer of 2048 samples and sends the buffer to the reconfigurable circuit 103 for FFT calculations. The results of the FFT are applied to calculate the THD and the asymmetry values. The THD and asymmetry are aggregated in the same interval as the rms signal.

The flicker block calculates the short-term flicker (PST - every 10 minutes) and the long-term flicker (PLT - every 2 hours). The flicker calculations are synchronized to the GPS time signal.

Every calculated value (rms, THD, asymmetry and flicker) is extended by the timestamp read from a GPS receiver.

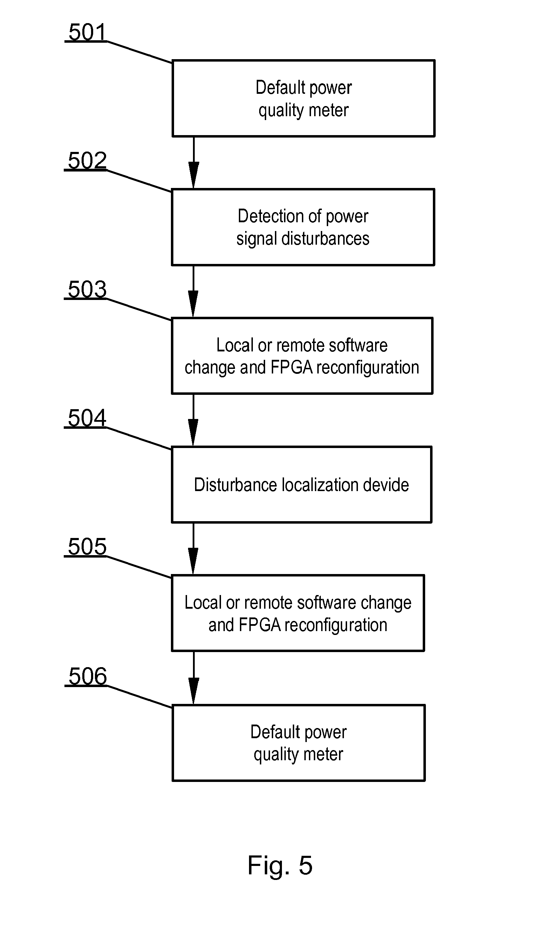

Fig. 5 shows a method according to the present invention. The power quality measurement device, shown in Fig. 1, may be changed 503 into another measurement unit from its then current setup 501, 502. The change 503 relates to both software change and reconfiguration of the hardware-implemented functions built as FPGA blocks. The change does not require any hardware modifications and can be performed unlimited number of times. The change can be permanent or temporary and the device can return into power quality measurement functions 506 after a cycle of measurements of another kind 505.

If a condition that requires a new function is detected 502 the device itself of an operator remotely can change both software and FPGA-based hardware configuration 503. For example, if the power quality indices indicate significant power signal disturbances the power quality meter can be switched into a disturbance localization device 504.

Another case that require device reconfiguration are new measurement requirements of the power grid operator. The change can be permanent or after a period of new operating mode the device can be reconfigured once more 505 and return to its default operating mode 506.

The device can store locally a library of configurations and change the functions up to requirements.

The presented system and method allow for high speed and adaptive detection of power quality. Therefore, the invention provides a useful, concrete and tangible result.

Further, the input, physical signals are input to a processing circuit that applies specific data processing techniques. Thus, the machine or transformation test is fulfilled and that the idea is not abstract.

It can be easily recognized, by one skilled in the art, that the aforementioned method for measuring quality of power may be performed and/or controlled by one or more computer programs. Such computer programs are typically executed by utilizing the computing resources in a computing device. Applications are stored on a non-transitory medium. An example of a non-transitory medium is a non-volatile memory, for example a flash memory while an example of a volatile memory is RAM. The computer instructions are executed by a processor.

These memories are exemplary recording media for storing computer programs comprising computer-executable instructions performing all the steps of the computer-implemented method according the technical concept presented herein.

While the invention presented herein has been depicted, described, and has been defined with reference to particular preferred embodiments, such references and examples of implementation in the foregoing specification do not imply any limitation on the invention. It will, however, be evident that various modifications and changes may be made thereto without departing from the broader scope of the technical concept. The presented preferred embodiments are exemplary only, and are not exhaustive of the scope of the technical concept presented herein.

Accordingly, the scope of protection is not limited to the preferred embodiments described in the specification, but is only limited by the claims that follow.

**Claims**

1. A system for measuring power quality, the system comprising:

   • a first processor (101);
   • a computer-readable memory; and
   • an interface communicatively coupled to A/D converters (105);

   the system being **characterized in that** it further comprises:

   • the first processor (101) configured to execute a general-purpose operating system implementing communication procedures;
   • a second processor (102) configured to execute a real-time operating system dedicated for time-critical tasks;
   • a reconfigurable hardware system (103), configured to be controlled by the first processor (101), the reconfigurable system configured to execute at least one data processing algorithm (104) and perform data acquisition from the interface communicatively coupled to A/D converters (105) in order to measure power quality.

2. The system according to claim 1 **characterized in that** the data processing algorithm (104) is at least one of filtering, calculating spectrum, flicker, logging events.

3. The system according to claim 1 **characterized in that** the reconfigurable system (103) further comprises a module implementing at least one protection algorithm (106).

4. The system according to claim 3 **characterized in that** the at least one protection algorithm calculates overcurrent or overvoltage integral of an input signal.

5. The system according to claim 1 **characterized in that** the real-time operating system dedicated for time-critical tasks calculates at least one of rms values, flicker and asymmetry.

6. The system according to claim 1 **characterized in that** the second processor (102) is configured to acquire A/D samples into buffers and periodically send the buffered data to the reconfigurable system (103) for processing and to read the processing results.

7. The system according to claim 1 **characterized in that** the second processor (102) is configured to collect 2048 samples in the buffers and write, five times per second, the data of the buffers to an FFT calculation block of the reconfigurable system (103).

8. The system according to claim 1 **characterized in that** it is configured to update the at least one data processing algorithm (104) via a reconfiguration process.

9. A method for measuring power quality in the system according to claim 1, the method being **characterized in that** it comprises the steps of:

   • awaiting till the beginning of each sampling period (301);
   • starting A/D conversions (302);
   • awaiting for the conversion-completed signal (303);
   • reading (304) the conversion results; and
   • outputting the results are set (305) together with a timestamp value read from a GPS receiver (307).

10. The method according to claim 9 **characterized in that** it further comprises the steps of:

    • processing the output results by an event detection block (207), implemented in the reconfigurable system (103), configured to detect abnormal events;
    • storing the output results in a memory buffer (208);
    • processing (209) the output results in order to detect measured properties being outside a safe operating range.

11. The method according to claim 9 being **characterized in that** it further comprises a steps of:

    • detecting a condition that requires a new function (502);

• updating the hardware configuration (503) of the reconfigurable system (103);
• processing the input data according to the new hardware configuration.

12. A computer program comprising program code means for performing all the steps of the computer-implemented method according to claim 9 when said program is run on a computer.

13. A computer readable medium storing computer-executable instructions performing all the steps of the computer-implemented method according to claim 9 when executed on a computer.

101

Processor A

102

Processor B

103

FPGA

104

Filters, logging
FFT, Flicker

105

A/D Interface

106

Protection

107

A/D

Fig. 1

Fig. 2

<u>301</u>

Wait till the beginning of the next
sampling period (10.24 kHz)

<u>302</u>

Trigger A/D conversion

<u>306</u>

Read GPS timestamp

<u>303</u>

Wait till the end of
the conversion

<u>304</u>

Read the results
of the conversion

<u>305</u>

Set the output of the block
(A/D result and timestamp)

Fig. 3

Fig. 4

501 — Default power quality meter

502 — Detection of power signal disturbances

503 — Local or remote software change and FPGA reconfiguration

504 — Disturbance localization devide

505 — Local or remote software change and FPGA reconfiguration

506 — Default power quality meter

Fig. 5

Europäisches
Patentamt

European
Patent Office

Office européen
des brevets

# EUROPEAN SEARCH REPORT

Application Number

EP 14 20 0271

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/228224 A1 (SPANIER JOSEPH [US] ET AL) 10 September 2009 (2009-09-10) * paragraphs [0021], [0118] - [0130], [0143], [0160], [0179] - [0233], [0288], [0294] * | 1-13 | INV. G01R19/25 |
| X | US 2013/158906 A1 (GUO QIAO [CN] ET AL) 20 June 2013 (2013-06-20) * paragraphs [0010], [0026], [0028], [0043] - [0072], [0089], [0094] * | 1-13 | |
| X<br>A | US 2003/014200 A1 (JONKER RENE T [CA] ET AL) 16 January 2003 (2003-01-16) * paragraphs [0013], [0087] - [0096], [0119], [0122] - [0124], [0213], [0216] - [0218], [0234] - [0249]; figures 7,8,11 * | 1,9,12, 13<br>2-8,10, 11 | |
| X<br>A | US 2009/327787 A1 (YU YI GANG [CN] ET AL) 31 December 2009 (2009-12-31) * paragraphs [0003] - [0015], [0029] - [0054] * | 1,9,12, 13<br>2-8,10, 11 | TECHNICAL FIELDS SEARCHED (IPC)<br><br>G01R |

The present search report has been drawn up for all claims

| Place of search | Date of completion of the search | Examiner |
|---|---|---|
| Munich | 18 May 2015 | O'Callaghan, D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 14 20 0271

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2015

| Patent document cited in search report | | Publication date | Patent family member(s) | | Publication date |
|---|---|---|---|---|---|
| US 2009228224 | A1 | 10-09-2009 | US 2009228224 A1<br>US 2013158918 A1<br>US 2014222357 A1 | | 10-09-2009<br>20-06-2013<br>07-08-2014 |
| US 2013158906 | A1 | 20-06-2013 | NONE | | |
| US 2003014200 | A1 | 16-01-2003 | CA 2299043 A1<br>US 6615147 B1<br>US 6687627 B1<br>US 2003014200 A1<br>US 2005027464 A1<br>US 2006066456 A1 | | 09-02-2001<br>02-09-2003<br>03-02-2004<br>16-01-2003<br>03-02-2005<br>30-03-2006 |
| US 2009327787 | A1 | 31-12-2009 | CN 101614760 A<br>US 2009327787 A1 | | 30-12-2009<br>31-12-2009 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 5899960 A